# EUROPEAN PATENT SPECIFICATION

(11) **EP 0 571 691 B1**
(45) Date of publication and mention of the grant of the patent: **18.09.1996**
(21) Application number: 92830265.2
(22) Date of filing: 27.05.1992
(51) Int. Cl.: H01L 21/768, H01L 21/321

(54) **Metallization over tungsten plugs**
Verdrahtung auf Wolfram-Plomben
Métallisation sur des plots de tungstène

(43) Date of publication of application: 01.12.1993
(73) Proprietor: SGS-THOMSON MICROELECTRONICS S.r.l., I-20041 Agrate Brianza (Milano) (IT)
(72) Inventor: Marangon, Maria Santina, I-20063 Cernusco sul Naviglio (IT); Marmiroli, Andrea, I-24022 Alzano Lombardo (IT); Desanti, Giorgio, I-20124 Milano (IT)
(74) Representative: Pellegri, Alberto

(56) References cited:
- EP-A- 0 343 698
- US-A- 4 980 018
- IEEE TRANSACTIONS ON SEMICONDUCTOR MANUFACTURING vol. 3, no. 4, November 1990, NEW YORK US, pp. 150-157; Paul E. RILEY et al.: 'Implementation of Tungsten Metallization In Multilevel Interconnection Technologies'
- EXTENDED ABSTRACTS vol. 90-1, no. 165, 1990, PRINCETON, NEW JERSEY US, pp. 248-249; J. THEISEN et al.: 'Maskless Tungsten Etch Process for Plug Fill'
- PATENT ABSTRACTS OF JAPAN vol. 16, no. 300 (E-1227) 2 July 1992 ; & JP-A-40 80 917

## Description

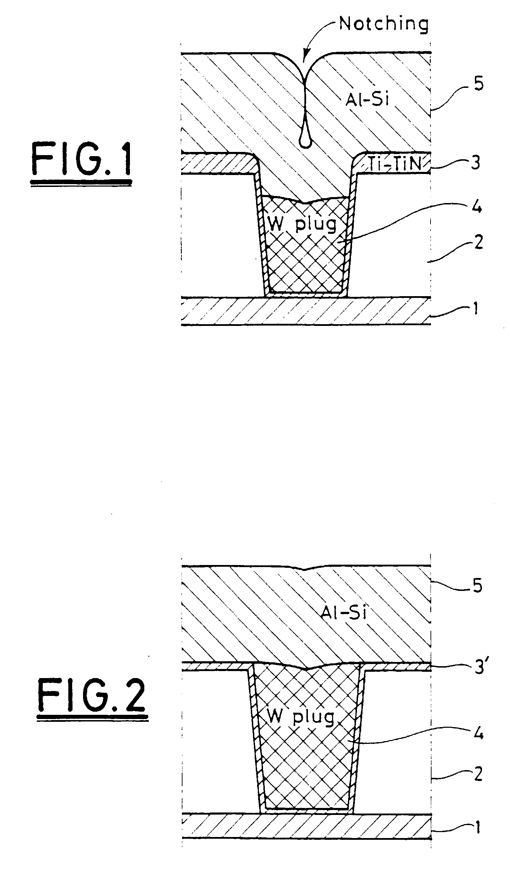

The present invention relates generally to the fabrication techniques of integrated devices with an extremely high degree of compactness (e.g. ULSI devices) such as memories, logic arrays and the like. The formation of submicrometer-size contacts with a semiconducting substrate and/or with conducting layers formed above the semiconducting substrate represents a very critical aspect of a manufacturing process because of the technological limitations which must be tackled with for ensuring continuity and uniformity of thickness of deposited metal layers used for forming the contacts. Aluminum and aluminum-silicon alloys, widely utilized in the past for filling contact holes and forcing metallization layers by sputter deposition, have proved inadequate for filling cavities having a submicrometric width such as contact openings (holes) prearranged through an isolation dielectric layer, commonly of silicon oxide. A technique of depositing a sufficiently conducting metallic material by chemical vapor deposition, (CVD) a deposition technique which ensures a most effective filling (step-coverage) of submicrometric cavities, has been developed and has rapidly found widespread application. The material most commonly used for this purpose is tungsten. Normally the technique comprises deposit of a barrier and adhesion layer or multilayer of titanium and/or of titanium nitride, having a total thickness which is commonly comprised between 50 and 200 nm, capable of coating the surface of the semiconductor at the bottom of the openings formed through a layer of dielectric material, as well as the walls of the contact hole through the dielectric layer and the surface of the dielectric layer. At the bottom of the contact hole, the titanium and/or titanium nitride layer prevents an eccessive diffusion of the subsequently deposited filler metal in the semiconducting substrate and at the same time favors the establishment of a good electrical continuity (low contact resistance) through the formation of an alloy with the silicon substrate at the metal semiconductor interface. Subsequently, a layer of tungsten is deposited by CVD to fill completely the contact holes. A blanket etching with a high selectivity toward the underlying titanium nitride adhesion layer eliminates the tungsten from the surface of the dielectric layer while leaving within the contact holes plugs of tungsten. A continued selective overetch of the tungsten, after a stop signal of the first etching step as detected upon exposing the titanium nitride adhesion layer, must necessarily be carried out for eliminating tungsten residues from the surface in correspondence of steps and other discontinuities from planarity of the surface itself. In this overetch phase, because of the "reduction" of the tungsten which is exposed to the selective plasma, the conditions are often such as to produce an eccessive undesirable baking off of the tungsten plugs which fill the contacts, leading to the formation of recessed plugs, i.e. whose top is eccessively recessed in respect to the plane of the surface which covered by the adhesion layer, of titanium nitride. This occurrence is often a cause of the formation of cavities during a subsequent sputter deposition of a metallization layer (metal) e.g. of aluminum-silicon alloy, because of the tendency of this material which is customarily deposited by sputtering, to notching phenomena, as illustratively shown in Fig. 1. On the other hand, the concurrent etching off of the adhesion layer of titanium nitride from the surface of the dielectric with the purpose of reducing the ultimate recession of the tungsten plugs in respect to the plane of the surface, before depositing a metallization layer of an aluminum-silicon alloy, though reducing the tendency of the metallization layer to form occluded or not occluded empty zones over recessed tungsten plugs, to cause a weakening in terms of long term reliability of the devices, especially because of electromigration phenomena of the Al/Si alloy.

US-A-4 980 018 and the article in IEEE Transactions on Semiconductor Manufacturing, vol. 3, no. 4, 1990 by P.E.Riley et al., disclose a method of forming tungsten plugs whereby in a second etching step an adhesion layer of TiN with W residues thereon is completely etched away.

It has now been found that by stopping the blanket etch of the deposited tungsten upon the exposure of the underlying layer of titanium nitride, i.e. essentially without continuing with an overetch phase of the tungsten for eliminating tungsten residues from the surface in correspondence of steps, any backing off of the top of the tungsten plugs of the contacts is prevented. At this point, by modifying the selectivity condition of the blanket plasma etch in order to reduce the selectivity sufficiently to produce also a substantial etching of the titanium nitride together with the tungsten, a second etching step is performed during which the residues of tungsten on the surface are effectively eliminated and at the same time with a "lowering" of the tops of the tungsten plugs in the contacts, a similar "lowering" of the top surface of the titanium nitride adhesion layer is obtained, being also this material subject to etch. In this manner the front of the device is etched in a substantially uniform way without producing a recession of the tungsten plugs in respect to the rest of the surface. This second etching step, conducted under reduced selectivity conditions toward titanium nitride, is continued until ensuring an effective removal of any residue of tungsten from the surface but essentially before completely eliminating the adhesion layer of titanium nitride from the same surface. In this way, by means of only two etching steps, three advatageous results are achieved: a) removal of residues of tungsten from the surface; b) conservation of a residual of a titanium nitride adhesion layer on the surface; and c) prevention of any substantial recession of the tungsten plugs in the contacts.

The permanence of a residual layer of titanium nitride between a metallization layer of an aluminum alloy and the underlying dielectric layer, commonly of an oxide, inhibits or reduces the rate of electromigration phenomena which notably produce a "flow" of the metallization aluminum alloy in a direction opposite to the conventional direction of the electric current causing interruptions of electrical continuity in metal lines.

The etch selectivity of tungsten toward titanium nitride which essentially derives from the use of a fluorine based plasma (e.g. an SF₆ plasma) and which may be comprised between about 30/1 and about 15/1, during the first tungsten etch may be reduced to between 15/1 and about 1/10 by adding chlorine to SF₆ clorine in a quantity sufficient to reduce the etch selectivity of tungsten versus titanium nitride to said range for carrying out a second etching step.

**Figure 1** schematically depicts the notching of an Al-Si metallization layer above a recessed tungsten plug.

**Figure 2** is a partial microsection showing the result that is obtained with the improved process of the invention.

With reference to Fig. 1, a contact with a semiconducting substrate 1, covered with a dielectric layer 2, is formed by making a hole through the dielectric 2 until exposing the surface to be contacted (e.g. of the semiconducting substrate 1) and depositing a barrier/adhesion layer of titanium and/or of titanium nitride 3 or only of titanium nitride, depositing a filling layer of tungsten by chemical vapor deposition (CVD) and subsequently etching the deposited tungsten layer until exposing the surface of the adhesion layer 3 of titanium nitride. The required further overetch step of tungsten in order to remove residues of this metal from the surface, along discontinuities of the surface from perfect planarity (e.g. steps, trenches, etc.), produces a recession of the top of the tungsten plug 4 in the contact. The occurrence of excessively recessed tungsten plugs 4 may cause, as depicted in Fig. 1, a notching phenomena of the metallization layer, e.g. an aluminum-silicon alloy deposited by sputtering, which may determine the formation of an occluded or (non-occluded) cavity above a recessed contact. The thinning of the conducting cross section of the metallization layer in these hollow zones may cause a localized overheating which may lead to an interruption of electrical continuity.

By contrast, in accordance with the improved process of the invention, by interrupting the tungsten etch upon exposing the adhesion layer 3 of titanium nitride and by modifying the etch selectivity conditions before performing a second etching step of the tungsten residues on the surface, and inevitably also of the top of the tungsten plugs 4 as well as of the adhesion layer 3 of titanium nitride, produces, beside the desired complete removal of any tungsten residues from the surface, a lowering, substantially in a coplanar manner, of the etch front both on the titanium nitride present on the surface, as well as on the tungsten plugs 4. This second etching step is interrupted before exposing the underlying surface of the dielectric layer 2, thus leaving a residual layer 3', though thinned out, of titanium nitride on the surface of the dielectric layer 2. The stack composed of the titanium nitride residual layer 3' and the metallization layer 4 may then be patterned as needed for defining the required metal lines. This ensures a better resistance to electromigration of a metallization film of aluminum-silicon alloy. It has been found, in fact, that on overheating, the tendency of the aluminum alloy to electromigrate over a dielectric oxide substrate, as often is the isolation layer 2, is strongly inhibited by the presence of a residual layer of titanium nitride 3' at the interface between the aluminum metal and an oxide sublayer layer 2.

## Claims

1. A process of forming a metallization film over tungsten plugs, formed by defining and etching openings through a dielectric layer, depositing an adhesion layer of titanium nitride, depositing a tungsten layer on the adhesion layer and etching the tungsten until exposing the adhesion layer of titanium nitride on the surface of said dielectric layer under etch selectivity conditions of tungsten versus titanium nitride, thus leaving said plugs of tungsten into said openings and tungsten residues along discontinuities from planarity of said surface, characterized by comprising
stopping said first etching step upon exposing said adhesion layer of titanium nitride;
modifying said etch selectivity conditions by reducing etch selectivity sufficiently to produce also an etching of titanium nitride together with tungsten;
performing a second etching step under these modified selectivity conditions for said residues of tungsten from said surface while simultaneously etching said tungsten plugs and said adhesion layer of titanium nitride, partially reducing the thickness of the latter;
depositing a metallization layer over a residual layer of titanium nitride and over said tungsten plugs;
patterning a stack composed of said metallization layer and said residual layer of titanium nitride.

2. A process as defined in claim 1, wherein said etch selectivity of tungsten versus titanium nitride during said first etching step is comprised bewteen 30/1 and 15/1 and etch selectivity during said second etching step is reduced to within 15/1 and 1/10.

3. A process as defined in claim 2, wherein said first highly selective etching step is performed in a SF₆ plasma and said second etching step having a reduced selectivity is performed in a plasma of SF₆ and Cl₂.

## Patentansprüche

1. Verfahren zum Bilden eines Metallisierungsfilmes über Wolframsteckern, gebildet durch Definieren und Ätzen von Öffnungen durch eine dielektrische Lage, Ablagern einer Klebstofflage aus Titannitrit, Ablagern einer Wolframlage an der Klebstofflage und Ätzen des Wolframs bis zur Freilegung der Klebstofflage aus Titannitrit an der Oberfläche der dielektrischen Lage unter Ätzselektivitätsbedingungen von Wolfram gegenüber Titannitrit, wodurch die Stecker aus Wolfram in den Öffnungen und Wolfram entlang Diskontinuitäten von der Planarität der Oberfläche verbleiben, dadurch gekennzeichnet, daß das Verfahren umfaßt
- Stoppen des ersten Ätzschrittes beim Freilegen der Klebstofflage aus Titannitrit;
- Modifizieren der Ätzselektivitätsbedingungen durch ausreichendes Reduzieren der Ätzselektivität, um ebenfalls ein Ätzen des Titannitrits zusammen mit Wolfram zu erzeugen;
- Durchführen eines zweiten Ätzschrittes unter diesen modifizierten Selektivitätsbedingungen für die Reste von Wolfram von der Oberfläche, während gleichzeitig die Wolframstecker und die Klebstofflage aus Titannitrit geätzt werden, wobei teilweise die Dicke der letzteren reduziert wird;
- Ablagern einer Metallisierungslage über einer Restlage aus Titannitrit und über den Wolframsteckern;
- Bemustern eines Stapels, gebildet aus der Metallisierungslage und der Restlage aus Titannitrit.

2. Verfahren nach Anspruch 1, wobei die Ätzselektivität von Wolfram gegenüber Titannitrit während dem ersten Ätzschritt zwischen 30/1 und 15/1 liegt und die Ätzselektivität während dem zweiten Ätzschritt reduziert ist auf innerhalb 15/1 und 1/10.

3. Verfahren nach Anspruch 2, wobei der erste stark selektive Ätzschritt in einem SF₆ Plasma durchgeführt wird und der zweite Ätzschritt mit einer reduzierten Selektivität in einem Plasma von SF₆ und Cl₂ durchgeführt wird.

## Revendications

1. Procédé de formation d'une couche de métallisation sur des plots de tungstène, formés en définissant et en gravant des ouvertures dans une couche diélectrique, en déposant une couche d'adhérence en nitrure de titane, en déposant une couche de tungstène sur la couche d'adhérence et en gravant le tungstène jusqu'à exposer la couche d'adhérence en nitrure de silicium sur la surface de la couche diélectrique dans des conditions de gravure sélective du tungstène par rapport au nitrure de titane, laissant ainsi en place les plots de tungstène dans les ouvertures et des résidus de tungstène le long de discontinuités de planéité de la surface, caractérisé en ce qu'il comprend les étapes suivantes :
arrêter la première étape de gravure quand la couche d'adhérence en nitrure de titane est exposée ;
modifier les conditions de sélectivité de gravure en réduisant la sélectivité de gravure suffisamment pour produire également une gravure du nitrure de titane en même temps que du tungstène ;
réaliser une seconde étape de gravure dans ces conditions de sélectivité modifiée pour les résidus de tungstène sur la surface, tout en gravant simultanément les plots de tungstène et la couche d'adhérence de nitrure de titane, réduisant ainsi partiellement l'épaisseur de cette dernière ;
déposer une couche de métallisation sur une couche résiduelle de nitrure de titane et sur les plots de tungstène ;
définir un empilement constitué de la couche de métallisation et de la couche résiduelle de nitrure de titane.

2. Procédé selon la revendication 1, dans lequel la sélectivité de gravure du tungstène par rapport au nitrure de titane pendant la première étape de gravure est comprise entre 30/1 et 15/1 et la sélectivité de gravure pendant la deuxième étape de gravure est réduite à la plage comprise entre 15/1 et 1/10.

3. Procédé selon la revendication 2, dans lequel la première étape de gravure très sélective est réalisée dans un plasma de SF₆ et la deuxième étape de gravure ayant une sélectivité réduite est réalisée dans un plasma de SF₆ et de Cl₂.
